# EUROPEAN PATENT SPECIFICATION

(11) **EP 1 667 207 B1**
(45) Date of publication and mention of the grant of the patent: **17.07.2019**
(21) Application number: 04787750.1
(22) Date of filing: 08.09.2004
(51) Int. Cl.: H01L 21/02, H01L 27/12

(54) **BONDED WAFER AND ITS MANUFACTURING METHOD**
GEBONDETER WAFER UND HERSTELLUNGSVERFAHREN DAFÜR
TRANCHE COLLEE ET PROCEDE DE FABRICATION

(30) Priority: 08.09.2003 JP 2003315986
(43) Date of publication of application: 07.06.2006
(73) Proprietor: SUMCO Corporation, Tokyo 105-8634 (JP)
(72) Inventor: ENDO, Akihiko c/o Sumco Corporation, Tokyo 105-8634 (JP); NISHIHATA, Hideki c/o Sumco Corporation, Tokyo 105-8634 (JP)
(74) Representative: Beckmann, Claus
(86) International application number: PCT/JP2004/013067
(87) International publication number: WO 2005/027204

(56) References cited:
- EP-A- 0 410 679
- EP-A- 1 155 442
- WO-A1-00/48238
- JP-A- 4 003 908
- JP-A- 8 274 285
- JP-A- 9 008 124
- JP-A- 2001 345 435
- JP-A- 2002 536 843
- US-A- 6 004 860
- ZHE-CHUAN FENG, HONG-DU LIU: "Generalized formula for curvature radius and layer stresses caused by thermal strain in semiconductor multilayer structures" JOURNAL OF APPLIED PHYSICS, vol. 54, no. 1, 1983, pages 83-85, XP002527687

## Description

### FIELD OF THE INVENTION

The present invention relates to a bonded wafer and a manufacturing method of the same, and more particularly to a bonded wafer and a manufacturing method of the same, in which an area that has been left as not-bonded in an outer peripheral portion of the wafer is reduced so that a FQA (Fixed Quality Area) can be expanded.

### DESCRIPTION OF THE PRIOR ART

Recently, film thickness reduction of an active layer (0.05*µ*m or thinner) has been progressed in conjunction with a highly densified integration of devices. There has been developed the smart cut method as disclosed in Japanese Patent Laid-open Publication No. Hei 5-211128 as a method for manufacturing a semiconductor substrate having an SOI (Silicon On Insulator) structure for achieving the above-mentioned film thickness reduction.

In the smart cut method, firstly a wafer for active layer, which has been processed to have an oxide film formed thereon and then ion-implanted with hydrogen at a predetermined depth thereof via the oxide film, is bonded with a supporting wafer in a room temperature. Subsequently, thus obtained bonded wafer is introduced into a furnace for heat treatment, where it is heat treated at 500°C for 30 minutes to thereby cleave and separate a part of the active layer wafer at the site of the ion-implanted area. In this stage of processing, a specific area in an outer peripheral portion of the active layer wafer, which has been left as not-bonded due to a wafer geometry, is not cleaved or separated but the area will remain as it is in a main body portion of the active layer wafer. Following the above step, a heat treatment for bonding to enhance a bonding strength is applied to the bonded wafer. The heat treatment for bonding provides a heat treatment at 1100°C in an atmosphere of oxygen for two hours . Thus, an SOI wafer can be produced which comprises the supporting wafer and the active layer wafer with a buried silicon oxide film interposed therebetween.

In EP 1 155 442 A0 (corresponding to WO 00/48238), a manufacturing method of a bonded wafer and a bonded wafer are disclosed, which correspond to the preambles o claims 1 and 3. Further wafer bonding techniques are described in EP 0 410 679 A1 and in US 6,004,860.

### SUMMARY OF THE INVENTION

### Problem to be solved by the invention

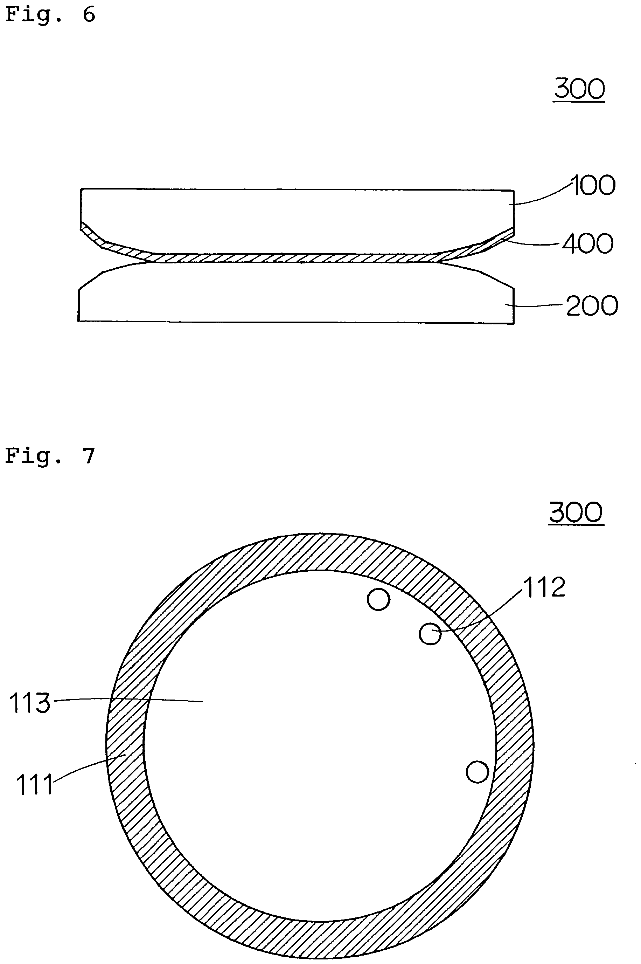

It is to be noticed that both of the active layer wafer and the supporting wafer have been mirror finished in their bonding surfaces by the MP (Mirror Polishing). The mirror finishing tends to induce abrasive drop in the outer peripheral portion of the wafer. As a result thereof, owing to this abrasive drop, the area left as not-bonded (EE (Edge Exclusion)) 111 is expanded in the outer peripheral portion of the bonded wafer 300 comprising the active layer wafer 100 and the supporting wafer 200 with the buried silicon oxide film 400 interposed therebetween and also a number of voids are generated in the bonding interface of the bonded wafer, as shown in Figs. 6 and 7. As a result, the fixed quality area 113 of the bonded SOI wafer and thus the yield of device obtainable from the bonded SOI wafer have been reduced.

Further, the portion corresponding to the area 111 in the outer peripheral portion of the wafer, which is left as not-bonded, has a deteriorated mechanical strength as compared to the other portion (i.e., the portion corresponding to the fixed quality area 113). Consequently, as the area left as not-bonded expands more broadly, chipping, wafer peel-off and the like phenomenon are more likely to occur in the subsequent steps of wafer processing.

The present invention has been made in the light of the problems described above, and an object thereof is to provide a bonded wafer and a manufacturing method thereof, in which the area left as not-bonded can be reduced and thus the fixed quality area can be enlarged in the outer peripheral portion of the wafer.

### Means to solve the problem

The present invention provides a manufacturing method of a bonded wafer according to claim land a bonded wafer according to claim 3. Dependent claim 2 defines a preferred embodiment of the manufacturing method.

In the manufacturing method of a bonded wafer, in which the bonded wafer is manufactured by bonding a wafer for active layer with a supporting wafer, wherein the active layer wafer and the supporting wafer, which are to be bonded together, have fitting surfaces, respectively, for fitting to each other, each of said fitting surfaces comprising a part of a spherical surface having the same curvature.

According to this process, the active layer wafer and the supporting wafer prepared for bonding together are to be bonded as their bonding surfaces abutting to each other. In this stage of processing, the bonding surfaces of those two wafers have the fitting surfaces, respectively, allowing for the fitting to each other. Owing to those arrangement, those two bonding surfaces can be superposed together even in the outer peripheral portion of the bonded wafer. This results in a reduced area left as not-bonded in the outer peripheral portion of the wafer. Consequently, it helps increase a fixed quality area allowable for the formation of devices within the bonded wafer. This can increase a yield of the bonded wafer and also can reduce chipping, wafer peel-off and the like phenomenon in the subsequent steps of wafer processing.

Specifically, as to the active layer wafer and the supporting wafer such types of wafer may be employed as a monocrystal silicon wafer, a germanium wafer and a silicon carbide wafer, for example.

The manufacturing method of the bonded wafer includes such a method for bonding in which after an insulating film is formed on an active layer wafer and the active layer wafer and a supporting wafer are bonded via the insulating film disposed therebetween, the bonded wafer is subjected to the steps of grinding and polishing so as to produce the SOI wafer including an SOI layer formed therein. This bonding method includes the smart cut method, in which the hydrogen gas or the noble gas element is ion-implanted into the active layer wafer via the insulating film to form the ion-implanted layer in the active layer wafer, subsequently the active layer wafer is bonded with the supporting wafer via the insulating film disposed therebetween to form the bonded wafer, and then thus obtained bonded wafer is subjected to the heat treatment so as to cleave and separate a part of the active layer wafer at the site of the ion-implanted layer as the interface.

The expression that the bonding surfaces of the two wafers provide the fitting surfaces means that a convex and a concave portions existing in the bonding surfaces have the same curvature but disposed oppositely so as to form complementary surfaces with each other. The curvature for the active layer wafer and the supporting wafer is not limited.

Further, at least either one of the fitting surface of the active layer wafer and the fitting surface of the supporting wafer includes a hetero structure along a thickness-wise direction.

The hetero structure refers to a structure containing different types of substance in contact with each other at the site of a certain interface. The area proximal to the interface between the different types of substance defines a hetero junction of two phases having a lattice structure, a chemical composition and a thermal expansion coefficient that are different from each other. Accordingly, a stress acts on the hetero junction, and so a strain will be induced therein. Owing to this strain, a warp (deformation) is generated in the wafer having the hetero structure.

Further, those different types of substance include a combination of the same substances exclusively having different dopant concentrations.

It is to be noted that the wafer subject to the arrangement of the hetero structure may be the active layer wafer or the supporting wafer. Alternatively, both of the active layer wafer and the supporting wafer may be provided with the hetero structure.

According to the invention, on the subject wafer to be provided with the hetero structure thereon (the active layer wafer and/or the supporting wafer), an epitaxial layer having a different dopant concentration (including a case of no dopant contained) from that of the subject wafer is grown epitaxially so as to create the hetero structure . Since the two wafers have different dopant concentrations from each other, the lattice constant for the substances constructing the two wafers is also different from each other. Owing to this, the strain will be generated in the vicinity of the bonding interface that will turn to be the hetero junction, and the warp will occur in the subject wafer. In this regard, thus emerged warp is used in a positive manner to thereby reduce the area that will otherwise be left as not-bonded and enlarge the fixed quality area usable for the formation of the devices .

According to the invention the hetero structure is provided along the thickness-wise direction in the epitaxial growth method.

The epitaxial growth method includes the vapor phase epitaxial growth method, the liquid phase epitaxial growth method and the solid phase epitaxial growth method. The vapor epitaxial growth method includes a chemical method (CVD method: Chemical Vapor Deposition) and a physical method (PVD method: Physical Vapor Deposition).

If the above-discussed film is deposited over the top and back surfaces of either one of the active layer wafer and the supporting wafer, the wafer will be curved (to warp) due to the thermal expansion constant or the chemical reaction.

According to an embodiment of the invention, for example, the epitaxial layer having the dopant concentration different from that of the active layer wafer or the supporting wafer is grown on the top and back surfaces of either one of those wafers (the epitaxial layer containing no dopant included in this case) . Owing to this, a stress acts on the site of junction between the epitaxial layer and the wafer, and thus the strain is generated therein. This strain leads to the warp (deformation) of the wafer that has been provided with the epitaxial layer (hetero structure) thereon. Then, taking advantage of the warp positively can reduce the area otherwise to be left as not-bonded in the outer peripheral portion of the wafer and thus can enlarge the fixed quality area where the devices can be formed.

According to an embodiment of the invention, the hetero structure is disposed in a top and a back surfaces, respectively, of the active layer wafer or the supporting wafer, and the hetero structure in the top and the back surfaces are different in thickness from each other.

According to this embodiment, it is possible to induce the warp in the subject wafer even in the method employing the different film thickness between the top surface and the back surface of the subject wafer. Differentiating the film thickness may be achieved easily by using an HF solution. Consequently, the bonded wafer having the effect from the present invention can be manufactured inexpensively.

According to an embodiment of the invention, the manufacturing method of a bonded wafer further comprises the steps of: ion-implanting of hydrogen gas or noble gas into the active layer wafer to form an ion-implanted layer in the active layer wafer; subsequently bonding the active layer wafer with the supporting wafer to form the bonded wafer; and then heat treating the bonded wafer by holding it at a predetermined temperature so as to induce a cleavage and separation at the site of ion-implanted layer as an interface.

The element to be ion-implanted maybe a type of noble gas, including, for example, helium (He), neon (Ne), argon (Ar), krypton (Kr), xenon (Xe) and radon (Rn), in addition to the hydrogen (H). Those elements may be provided in a single element or a chemical compound.

The dose of the light element for the ion-implantation is not limited. For example, the dose may be in a range of 2x10¹⁶ atoms/cm² to 8x10¹⁶ atoms/cm².

The acceleration voltage of the light element during the ion-implantation may be not higher than 50keV, preferably not higher than 30keV and more preferably not higher than 20keV. In the ion-implantation, using the lower acceleration voltage allows the ion to be controlled more precisely such that the ion can be concentrated in a depth of target.

The heating temperature of the bonded wafer during the cleavage process may be 400°C or higher, preferably in a range of 400°C to 700°C and more preferably in a range of 450°C to 550°C. It is difficult with the temperature lower than 400°C to form the bubbles of light element from the ion-implanted light element. Inversely, with the temperature higher than 700°C, the oxide deposit will be formed within the active layer and it may deteriorate the properties of devices.

The heat treatment for bonding to further enhance the bonding strength between the active layer wafer and the supporting wafer may be performed after the cleavage process. The condition of thermal treatment in this step may be defined by the heat treatment at 1100°C for two hours, for example. The atmospheric gas within the furnace for the thermal oxidation may employ oxygen, for example.

The atmosphere within the furnace during the cleavage process may be the atmosphere of non-oxidizing gas (e.g., an inactive gas such as nitrogen, argon). Alternatively, the process may be carried out in a vacuum condition.

The heating time of the bonded wafer for the cleavage may be one minute or longer, preferably in a range of 10 minutes to 60 minutes. With the heating time less than one minute, it is difficult to form the bubbles of light element which has been ion-implanted into the bonded wafer.

According to this embodiment, the active layer wafer and the supporting wafer, each having the fitting surfaces comprising a part of the spherical surface having the same curvature, are prepared. Then, the active layer wafer is ion-implanted with the hydrogen gas or the noble gas so as to form the ion-implanted layer in the active layer wafer. Subsequently, the active layer wafer and the supporting wafer are bonded together to form the bonded wafer, and after this step, the bonded wafer is held at the predetermined temperature for the heat treatment. This makes it possible for a part of the active layer wafer to be cleaved and separated across its entire surface at the site of the ion-implanted layer as the interface. Consequently, the SOI wafer can be obtained, which has been produced in the smart cut method and in which the area otherwise to be left as not-bonded in the outer peripheral portion of the wafer has been reduced and the fixed quality area has been enlarged.

The invention provides a bonded wafer manufactured by the above manufacturing method.

### Effect of the invention

According to the present invention, an active layer wafer and a supporting wafer, which are to be bonded together, have fitting surfaces, respectively, and each of those fitting surfaces comprises a part of a spherical surface having the same curvature. During bonding, the active layer wafer and the supporting wafer are bonded together at the site of bonding surfaces comprising the fitting surfaces which are brought into contact with each other. In this regard, taking advantage of those fitting surfaces positively, the area otherwise to be left as not-bonded in the outer peripheral portion of the wafers can be reduced and the fixed quality area where devices may be formed can be enlarged. Consequently, the yield of the bonded wafer can be increased and any chipping, peel-off of the wafer and the like phenomenon during the subsequent steps of wafer processing can be reduced.

### BRIEF DESCRIPTION OF THE DRAWINGS

Fig. 1 is a process chart showing a manufacturing method of a bonded wafer according to an embodiment of the present invention;
Fig. 2 is an enlarged section view of a main part showing a step of bonding in the manufacturing method of a bonded wafer according to the embodiment of the present invention;
Fig. 3 is a plan view showing an area to be left as not-bonded in a bonded wafer according to the embodiment of the present invention;
Fig. 4 is an enlarged section view of a main part of a bonded wafer showing a step of bonding in the manufacturing method of a bonded wafer according to another mode for carrying out the embodiment of the present invention;
Fig. 5 is a process chart of main steps of processing showing a further manufacturing method of a bonded wafer;
Fig. 6 is an enlarged section view of a main part showing a step of bonding in a manufacturing method of a bonded wafer according to the prior art means; and
Fig. 7 is a plan view showing an area to be left as not-bonded in a bonded wafer according to the prior art means.

### Description of reference numerals

- 10: Active layer wafer
- 12a: Silicon oxide film (Insulating film)
- 14: Hydrogen ion implanted area (Ion-implanted area)
- 20: Supporting wafer
- 30: Bonded wafer
- 40: Epitaxial layer

### DESCRIPTION OF THE PREFERRED EMBODIMENTS

Preferred embodiments of the present invention will nowbe described with reference to the attached drawings.

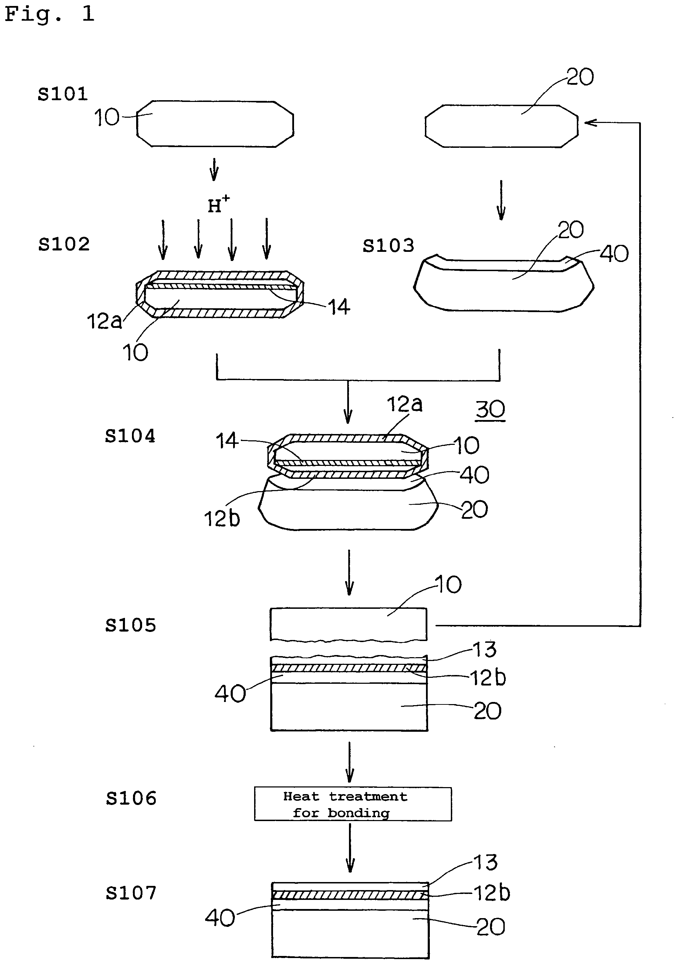

Firstly, a monocrystal ingot of silicon of p-type that has been doped with a predetermined quantity of boron is pulled up in the Cz method, as shown in step S101 of Fig. 1. The rate of pulling up is 1.0mm/min. After that, the monocrystal ingot of silicon undergoes a series of processing comprising block cutting, slicing, beveling and mirror polishing. Those steps of processing produce a wafer to be prepared as an active layer wafer 10 and a wafer to be prepared as a supporting wafer 20, each of which wafers is of p-type and mirror-polished having a thickness of 725 *µ*m, a diameter of 200mm, a face orientation of (100) face, a specific resistance of 10Ωcm.

Following that step, the active layer wafer 10 is introduced into a thermal oxidation device, where the thermal oxidation is applied to the active layer wafer 10 in an oxygen gas atmosphere, as shown in step S102 of Fig. 1. This forms a silicon oxide film 12a having the thickness of about 0.15 *µ*m entirely across the exposed surface of the active layer wafer 10. The condition of thermal treatment may be defined by the thermal treatment at 1000°C for eight hours.

Subsequently, an intermediate current ion implanting device is used to perform the ion-implantation of the hydrogen with an acceleration voltage of 50keV into the active layer wafer 10 at a predetermined depth measured from the mirror finished surface thereof. Thus the hydrogen ion implanted area 14 is formed in the active layer wafer 10. The dose used in this step is 5x10¹⁶ atoms/cm².

Subsequently, the supporting wafer 20 is introduced into a CVD device of single wafer processing type, though not shown, where an epitaxial layer 40 of P⁺ type having the boron concentration in a range of 5x10¹⁸ to 8x10¹⁸ atoms/cm³ grows over the mirror finished surface of the supporting wafer 20, as shown in step S103 of Fig. 1.

Specifically, the supporting wafer is loaded on a susceptor arranged in a reaction furnace of the epitaxial growth unit. After that, the SiHCl₃ gas (0.1 volume percent diluted by H₂ gas) is mixed with the B₂H₆ gas (partial pressure in a range of 2∼4x10⁻⁵), and the resultant mixture is supplied to the reaction furnace at a rate of 80 litter/min to cause the epitaxial layer 40 to grow on top of the supporting wafer 20.

The temperature used for the epitaxial growth is 1100°C. The thickness of the epitaxial layer 40 can be adjusted by changing the epitaxial growth time in dependence on a curvature of the surface (the fitting surface) of the active layer wafer 10. Thus, the epitaxial layer 40 having a specific resistance in a range of 10 to 15 mΩcm and including the surface (the fitting surface) in consistency with a convexity or concavity of the surface of the active layer wafer 10 can be formed on the surface of the supporting wafer 20. The growth of the epitaxial layer 40 causes the warp to be generated in the supporting wafer 20, so that a center region of the wafer may protrude toward the back surface. Owing to this, each of the fitting surfaces of the active layer wafer 10 and the supporting wafer 20 is formed to include a part of the spherical surface of the same curvature. Thus, the active layer wafer 10 and the supporting wafer 20 can be fitted to each other.

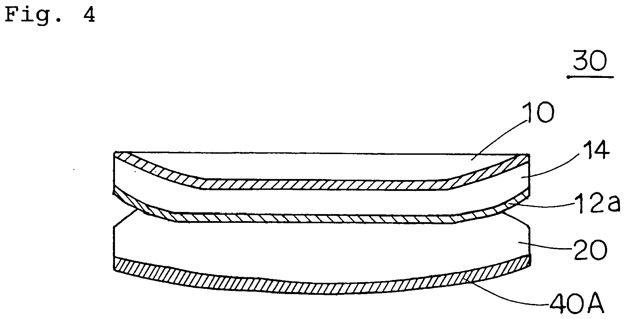

It is to be noted that if employing the boron concentration of 1x10¹⁹ atoms/cm³ in the supporting wafer 20 and the boron concentration of 1x10¹⁵ atoms/cm³ in the epitaxial layer 40A, which is lower than that in the supporting wafer 20, then the warp in the supporting wafer 20 defines a contour of the outer peripheral portion of the wafer that protrudes toward the back surface of the wafer. In this case, the back surface of the supporting wafer 20 is to be used as the bonding surface to produce a bonded wafer (see Fig.4). Alternatively, the epitaxial layer 40 may be grown not in the supporting wafer 20 but on top of the surface of the active layer wafer. Doing this can reduce a crystal defect, such as COP, in the active layer 13, as well.

Subsequently, the active layer wafer 10 and the supporting wafer 20 are bonded together by using the surface of the silicon oxide film 12a and the surface of the epitaxial layer 40 as the bonding surfaces (the superposed surfaces) with a known jig in a vacuum unit, for example, thus to produce the bonded wafer 30, as shown in step S104 of Fig. 1. As a result of this step, the silicon oxide film 12a at the junction between the active layer wafer 10 and the supporting wafer 20 defines a buried silicon oxide film (insulating film) 12b.

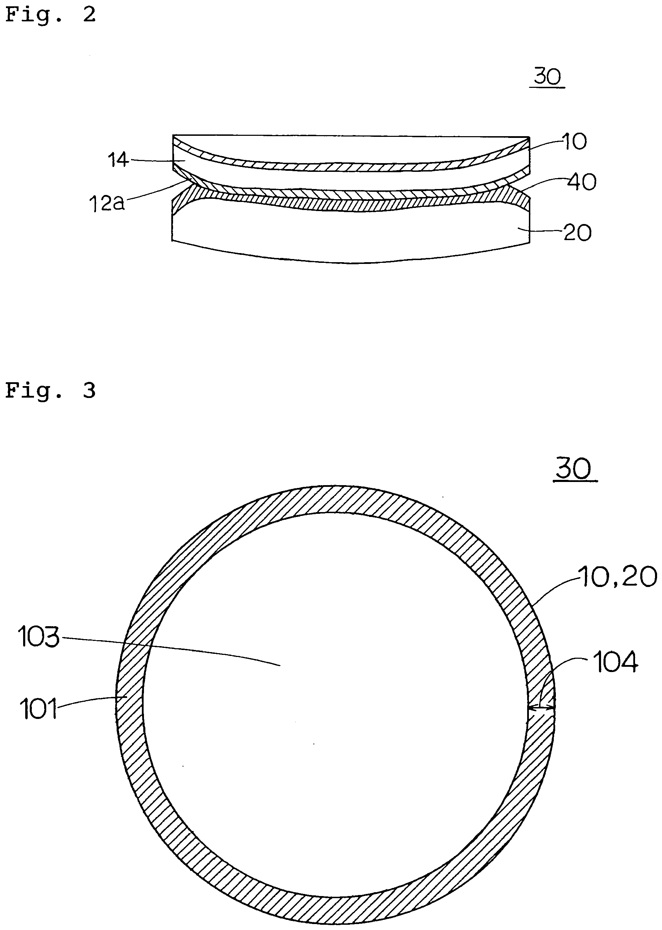

In the bonding, the bonding surfaces of the both wafers 10, 20 define the fitting surfaces that can be fitted to each other. This allows the bonding surfaces to be superposed not only in the central portion of the bonded wafer 30 but also in the outer peripheral portion of the wafer 30 (see Figs. 2 and 3). Consequently, a width 104 of the area 101 to be left as not-bonded in the outer peripheral portion of the bonded wafer 30 can be reduced to be 2 mm or narrower in comparison to the width of 2 to 3 mm in the prior art and thereby the generation of the void can be suppressed. Therefore, the fixed quality area 103 within the bonded wafer 30, which is usable for the devices to be formed, can be expanded in the order of 1% to 3% as compared with the conventional one. Consequently, the yield of the bonded SOI wafer can be improved and the problem of chipping, peel-off of the wafer and the like in the subsequent steps of wafer processing can be reduced, as well. It is to be noted that the width 104 of the area 101 left as not-bonded refers to the length of the area 101 left as not-bonded in the radial direction of the bonded wafer 30.

Then, the bonded wafer 30 is introduced into a thermal treatment device for cleavage, though not shown, and heat treated in an atmosphere of nitrogen gas at the furnace temperature of 500°C, as shown in step S105 of Fig. 1. The duration of heat treatment is 30 minutes. As a result of this thermal treatment, a part of the active layer wafer 10 is cleaved and separated from the bonded wafer 30 at the site of the hydrogen ion implanted area 14 while leaving the active layer 13 on the bonding interface of the supporting wafer 20. It is also possible to reuse the part of the active layer wafer 10, which has been cleaved off from the bonded wafer 30, as the silicon wafer serving as the supporting wafer 20 for the subsequent manufacturing process.

After the cleavage, the heat treatment for bonding is applied to the bonded wafer 30 in a nitrogen gas atmosphere at 1150°C for two hours, as shown in step S106 of Fig. 1. This treatment can enhance the bonding strength between the active layer wafer 10 and the supporting wafer 20.

Subsequently, the polishing is applied to the surface of the active layer 13 by a polishing device, as shown in step S107 of Fig. 1. Thus, the bonded SOI wafer (the bonded wafer) having the active layer 13 of about 0.2 *µ*m thick has been produced by taking advantage of the smart cut method.

A report on a result obtained from a comparison and examination with respect to the bonded SOI wafers produced in accordance with the present invention method and the prior art method, respectively, will be herein presented specifically on a relationship among the film thickness of the epitaxial layer grown on the surface of the supporting wafer, the warp in the supporting wafer, the number of void generation (as averaged over three pieces of wafers) in an area defined by 20mm in the radial direction of the wafer from the outermost peripheral edge of the bonded wafer, and the width of the area left as not-bonded (as averaged over three pieces of wafers) in the bonded SOI wafer.

As for the test condition used herein, the same as that in the embodiment was employed with an exception that no epitaxial layer growth was applied to the supporting wafer in the comparative example 1. The layer thickness of the epitaxial layer was measured by using a SIMS (Secondary Ion Mass Spectroscope). The warp of the supporting wafer was measured by an electrostatic capacity displacement gauge. Visual observation was employed in the examination for the number of void generation. In addition, the measurement by an optical microscope was employed after the cleavage for the purpose of measuring the width of the area left as not-bonded. Table 1 shows the result therefrom. It is to be noted that in Table 1, the number of void generation and the width of the area left as not-bonded indicate values averaged over three measured wafers.

**Table 1**

| | P⁺ Epitaxial layer thickness (*µ*m) | Warp of supporting wafer (reference taken as before epi-film deposition) (*µ*m) | Number of void generation in an area defined by 20mm from the wafer outer periphery (number) | Width of area left as not-bonded (mm) |
|---|---|---|---|---|
| Comparative example 1 | 0 | 0 | 2.3 | 2.2 |
| Test example 1 | 0.5 | 47 | 0.9 | 1.8 |
| Test example 2 | 1.0 | 92 | 0.6 | 1.6 |
| Test example 3 | 2.0 | 182 | 0.2 | 1.5 |

As clearly seen in Table 1, both of the number of void generation and the width of the area left as not-bonded have been improved favorably in any one of the test examples 1 to 3, in which the epitaxial layer growth was performed on the supporting wafer, as compared to the comparative example 1, in which no epitaxial layer growth was applied onto the supporting wafer.

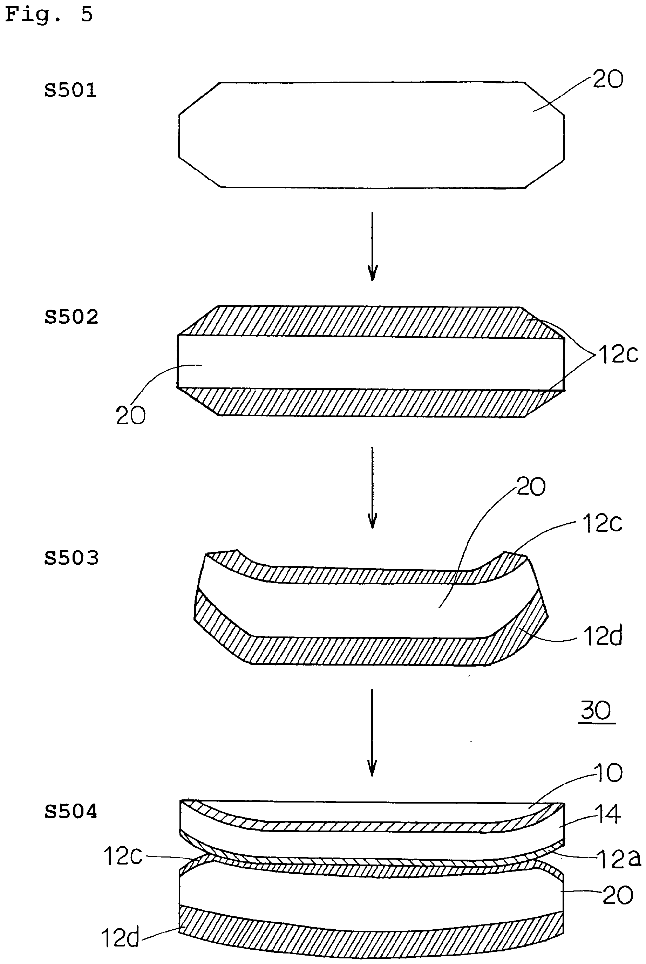

A further manufacturing method of a bonded wafer will now be described with reference to a process chart of Fig. 5.

The further manufacturing method represents an example of manufacturing method, in which firstly a hetero structure is provided by forming a silicon oxide film 12c, 12d entirely over an exposed surface of the supporting wafer 20, and secondly a warp is generated in the supporting wafer by differentiating the film thickness of the silicon oxide film in the top surface side (the silicon oxide film 12c) from that in the back surface side (the silicon oxide film 12d), as shown in Fig. 5.

Specifically, at first before the bonding step, the supporting wafer 20 is introduced into a thermal treatment device, where it is subjected to a heat treatment for oxidation in an oxygen gas atmosphere, as shown in step S501 and step S502 of Fig. 5. This produces the silicon oxide film 12c having the thickness of 0.3 *µ*m entirely over the exposed surface of the supporting wafer 20. The condition for the heat treatment is defined by a wet oxidation (a pyrogenic oxidation) at 950°C for one hour.

After that step, the supporting wafer 20 is loaded on a single side cleaning device of single wafer processing type, where the silicon oxide film 12c in the wafer top surface (the bonding surface) is exclusively brought into contact with an HF solution of one weight percent for a predetermined time so as to provide the etching in the top surface side of the wafer and thereby to form the thinner silicon oxide film 12c. As a result, the warp is generated in the supporting wafer 20, as shown in step S503 of Fig. 5. As the volume of etching increases, the film thickness difference of the silicon oxide film 12c in the top surface side from the silicon oxide film 12d in the back surface side of the wafer increases. Consequently, the degree of warp of the supporting wafer 20 is increased, as well. As shown in step S504 of Fig. 5, the degree of warp of the supporting wafer 20 is controlled in dependence on the curvature of the top surface (the fitting surface) of the active layer wafer 10 to be bonded together.

As discussed above, since the thickness of the silicon oxide film 12c, 12d has been differentiated between the top and the back surfaces of the supporting wafer 20 so as to induce the warp in the supporting wafer 20, therefore such an SOI bonded wafer that has achieved the effects from the embodiment can be manufactured inexpensively.

The configuration, operation and effect of the further manufacturing method are similar to those in the above embodiment, and so the description thereof is herein omitted.

A report on a result obtained from a comparison and examination with respect to the bonded SOI wafers produced in accordance with the present invention method and the prior art method, respectively, will be herein presented specifically on a relationship among the film thickness difference of the silicon oxide film between the top and the back surfaces of the supporting wafer, the warp in the supporting wafer, the number of void generation (as averaged over three pieces of wafers) in an area defined by 20mm in the radial direction of the wafer from the outermost peripheral edge of the bonded wafer, and the width of the area left as not-bonded (as averaged over three pieces of wafers) in the bonded SOI wafer.

As for the test condition used herein, the same as that in the embodiment was employed with an exception that no film thickness difference of the silicon oxide film between the top and the back surfaces of the supporting wafer is applied to the comparative example 2. The film thickness difference of the silicon oxide film between the top and the back surfaces of the supporting wafer was measured by using an ellipsometer. The warp of the supporting wafer was measured by an electrostatic capacity displacement gauge. An appearance observation with eyes was employed for determining the number of void generation. In addition, the measurement by using an optical microscope was employed for measuring the width of the area left as not-bonded. Table 2 shows the result therefrom. It is to be noted that in Table 2, the number of void generation and the width of the area left as not-bonded indicate values averaged over three measured wafers.

**Table 2**

| | Oxide film thickness difference between the top and the back surfaces of a supporting wafer (*µ*m) | Warp of supporting wafer (reference taken as before oxide film deposition) (*µ*m) | Number of void generation in an area defined by 20mm from the wafer outer periphery (number) | Width of area left as not-bonded (mm) |
|---|---|---|---|---|
| Comparative example 2 | 0 | 0 | 2.3 | 2.2 |
| Test example 4 | 0.05 | 1.6 | 2.1 | 2.1 |
| Test example 5 | 0.1 | 3.3 | 1.8 | 1.9 |
| Test example 6 | 0.2 | 6.2 | 1.1 | 1.9 |

As clearly seen in Table 2, both of the number of void generation and the width of the area left as not-bonded have been improved favorably in any one of the test examples 4 to 6, in which the film thickness difference of the silicon oxide film is provided between the top and the back surfaces of the supporting wafer, as compared to the comparative example 2, in which the film thickness of the silicon oxide film is identical between the top and the back surfaces of the wafer.

## Claims

1. A manufacturing method of a bonded wafer, in which said bonded wafer (30) is manufactured by bonding an active layer wafer (10) with a supporting wafer (20), wherein
said active layer wafer (10) and said supporting wafer (20), which are to be bonded together, have fitting surfaces, respectively, for fitting to each other, each of said fitting surfaces comprising a part of a spherical surface having the same curvature, and said fitting surface of said active layer wafer (10) and/or said fitting surface of said supporting wafer (20) includes a hetero structure provided on the subject wafer (10, 20) along a thickness-wise direction, and by a strain generated due to said hetero structure, a warp is formed in said active layer (10) and/or said supporting wafer (20),
**characterized in that**
said hetero structure is provided in the epitaxial growth method and includes an epitaxial layer (40) formed of the same substance as the subject wafer (10, 20) but having a dopant concentration which is different from that of the subject wafer (10, 20).

2. A manufacturing method of a bonded wafer in accordance with claim 1, comprising the steps of
ion-implanting of hydrogen gas or noble gas into said active layer wafer (10) to from an ion-implanted layer (14) in said active layer wafer (10);
subsequently bonding said active layer wafer (10) with said supporting wafer (20) to form said bonded wafer (30); and then
heat treating said bonded wafer (30) by holding it at a predetermined temperature so as to induce a cleavage and separation at the site of ion-implanted layer (14) as an interface.

3. A bonded wafer (30) manufactured by bonding an active layer wafer (10) with a supporting wafer (20), in which
said active layer wafer (10) and said supporting wafer (20), which are to be bonded together, have fitting surfaces, respectively, for fitting to each other, each of said fitting surfaces comprising a part of a spherical surface having the same curvature, and
said fitting surface of said active layer wafer (10) and/or said fitting surface of said supporting wafer (20) includes a hetero structure provided on the subject wafer (10, 20) in a thickness-wise direction, and by a strain generated due to said hetero structure, a warp is formed in said active layer (10) and/or said supporting wafer (20),
**characterized in that**
said hetero structure includes an epitaxial layer (40) formed of the same substance as the subject wafer (10, 20) but having a dopant concentration which is different from that of the subject wafer (10, 20).

## Patentansprüche

1. Herstellungsverfahren für einen gebondeten Wafer, bei welchem der gebondete Wafer (30) hergestellt wird durch Bonden eines Aktivschichtwafers (10) mit einem Trägerwafer (20), wobei
der Aktivschichtwafer (10) und der Trägerwafer (20), welche miteinander zu bonden sind, jeweils eine Passungsfläche zur Passung miteinander aufweisen, wobei jede der Passungsflächen einen Teil einer Kugeloberfläche mit derselben Krümmung umfasst, und die Passungsfläche des Aktivschichtwafers (10) und/oder die Passungsfläche des Trägerwafers (20) eine Heterostruktur aufweist, welche auf dem betreffenden Wafer (10,20) entlang einer Dickenrichtung vorgesehen ist, und durch eine aufgrund der Heterostruktur erzeugten Verspannung eine Krümmung indemAktivschicht-(10) und/oder dem Trägerwafer (20) gebildet wird,
**dadurch gekennzeichnet, dass**
die Heterosstruktur mit dem Epitaxie-Wachstumsverfahren bereitgestellt wird und eine epitaktische Schicht (40) beinhaltet, welche aus derselben Substanz wie der betreffende Wafer (10,20) gebildet ist, jedoch eine Dotierstoffkonzentration aufweist, welche sich von derjenigen des betreffenden Wafers (10,20) unterscheidet.

2. Herstellungsverfahren für einen gebondeten Wafer gemäß Anspruch 1, umfassend die Schritte
Ionenimplantieren von Wasserstoffgas oder Edelgas in den Aktivschichtwafer (10), um eine ionenimplantierte Schicht (14) in dem Aktivschichtwafer (10) auszubilden;
anschließend Bonden des Aktivschichtwafers (10) mit dem Trägerwafer (20), um den gebondeten Wafer (30) auszubilden; und dann
Wärmebehandeln des gebondeten Wafers (30), indem er bei einer vorbestimmten Temperatur gehalten wird, eine Spaltung und Trennung an der Stelle der ionenimplantierten Schicht (14) als Trennfläche zu veranlassen.

3. Gebondeter Wafer (30), welcher durch Bonden eines Aktivschichtwafers (10) mit einem Trägerwafer (20) hergestellt ist, bei welchem
der Aktivschichtwafer (10) und der Trägerwafer (20), welche miteinander zu bonden sind, jeweils eine Passungsfläche zur Passung miteinander aufweisen, wobei jede der Passungsflächen einen Teil einer Kugeloberfläche mit derselben Krümmung umfasst, und
die Passungsfläche des Aktivschichtwafers (10) und/oder die Passungsfläche des Trägerwafers (20) eine Heterostruktur beinhaltet, welche auf dem betreffenden Wafer (10,20) in einer Dickenrichtung vorgesehen ist, und durch eine aufgrund der Heterostruktur erzeugten Verspannung eine Krümmung in dem Aktivschicht-(10) und/oder dem Trägerwafer (20) ausgebildet ist,
**dadurch gekennzeichnet, dass**
die Heterostruktur eine epitaktische Schicht (40) beinhaltet, welche aus derselben Substanz wie der betreffende Wafer (10,20) gebildet ist, jedoch eine Dotierstoffkonzentration aufweist, welche sich von derjenigen des betreffenden Wafers (10,20) unterscheidet.

## Revendications

1. Procédé de fabrication d'une plaquette liée, dans lequel ladite plaquette liée (30) est fabriquée en liant une plaquette de couche active (10) à une plaquette de support (20), dans lequel
ladite plaquette de couche active (10) et ladite plaquette de support (20), qui doivent être liées l'une à l'autre, ont respectivement des surfaces d'ajustement pour s'ajuster l'une à l'autre, chacune desdites surfaces d'ajustement comprenant une partie d'une surface sphérique ayant la même courbure, et ladite surface d'ajustement de ladite plaquette de couche active (10) et/ou ladite surface d'ajustement de ladite plaquette de support (20) inclu(en)t une hétéro-structure prévue sur la plaquette en question (10, 20) suivant une direction d'épaisseur, et par une contrainte générée en raison de ladite hétéro-structure, une déformation est formée dans ladite couche active (10) et/ou ladite plaquette de support (20),
**caractérisé en ce que**
ladite hétéro-structure est fournie dans le procédé de croissance épitaxiale et inclut une couche épitaxiale (40) formée de la même substance que la plaquette en question (10, 20) mais ayant une concentration en dopant différente de celle de la plaquette en question (10, 20).

2. Procédé de fabrication d'une plaquette liée selon la revendication 1, comprenant les étapes
d'implantation ionique d'hydrogène gazeux ou de gaz rare dans ladite plaquette de couche active (10) d'une couche traitée par implantation ionique (14) dans ladite plaquette de couche active (10) ;
de liaison consécutive de ladite plaquette de couche active (10) à ladite plaquette de support (20) pour former ladite plaquette liée (30) ; et ensuite
de traitement thermique de ladite plaquette liée (30) en la maintenant à une température prédéterminée de manière à induire un clivage et une séparation au niveau du site de la couche traitée par implantation ionique (14) en tant qu'interface.

3. Plaquette liée (30) fabriquée en liant une plaquette de couche active (10) à une plaquette de support (20), dans laquelle
ladite plaquette de couche active (10) et ladite plaquette de support (20), qui doivent être liées l'une à l'autre, ont respectivement des surfaces d'ajustement pour s'ajuster l'une à l'autre, chacune desdites surfaces d'ajustement comprenant une partie d'une surface sphérique ayant la même courbure, et
ladite surface d'ajustement de ladite plaquette de couche active (10) et/ou ladite surface d'ajustement de ladite plaquette de support (20) inclu(en)t une hétéro-structure prévue sur la plaquette en question (10, 20) suivant une direction d'épaisseur, et par une contrainte générée en raison de ladite hétéro-structure, une déformation est formée dans ladite couche active (10) et/ou ladite plaquette de support (20),
**caractérisé en ce que**
ladite hétéro-structure inclut une couche épitaxiale (40) formée de la même substance que la plaquette en question (10, 20) mais ayant une concentration en dopant différente de celle de la plaquette en question (10, 20).
